# EUROPÄISCHE PATENTSCHRIFT

(11) **EP 2 098 294 B1**
(45) Veröffentlichungstag und Bekanntmachung des Hinweises auf die Patenterteilung: **28.12.2011**
(21) Anmeldenummer: 09002085.0
(22) Anmeldetag: 14.02.2009
(51) Int. Cl.: B01L 3/00, B01L 9/06, G01R 33/30

(54) **Probengestell zur Bereitstellung einer Vielzahl von Probengefässen, insbesondere NMR-Probenröhrchen**
Sample chassis for preparing a number of sample containers, in particular NMR sample test tubes
Porte-échantillons destiné à la préparation d'une multitude de récipients d'échantillons, notamment des petits tuyaux d'échantillons RMN

(30) Priorität: 21.02.2008 DE 102008010402
(43) Veröffentlichungstag der Anmeldung: 09.09.2009
(73) Patentinhaber: Bruker BioSpin AG, 8117 Fällanden (CH)
(72) Erfinder: Himmelsbach, Kurt, 8320 Fehraltdorf (CH); Grossniklaus, Beat, 8173 Riedt (CH)
(74) Vertreter: Kohler Schmid Möbus

(56) Entgegenhaltungen:
- WO-A-2005/073097
- DE-A1- 2 629 155
- DE-U1- 20 012 472
- DE-U1- 20 314 517
- US-B1- 6 202 878

## Beschreibung

Die Erfindung betrifft ein System zur Bereitstellung einer Vielzahl von Probengefäßen, insbesondere Probenröhrchen,
umfassend ein Probengestell mit einer Vielzahl von Halterungen, in denen jeweils ein Probengefäß angeordnet ist,
wobei das System weiterhin Kappen umfasst, wobei jeweils eine Kappe über das offene Ende eines Probengefäßes gestülpt ist, wobei die Kappe eine Bohrung aufweist, durch die das Innere des Probengefäßes zugänglich ist, und wobei das System weiterhin eine Vielzahl von Verschlusskügelchen umfasst, mit denen die Bohrungen der Kappen verschließbar sind.

Ein solches System ist aus der DE 203 14 517 U1 bekannt. Weiterhin sind Probengestelle zur Bereitstellung von Probengefäßen sind in vielfältiger Weise bekannt geworden, beispielsweise durch das "72 Position NMR Tube Rack", Item No. TR500 der Norell Inc., Landisville, NJ, USA.

Die instrumentelle Analytik, insbesondere auch die Kernspinresonanz(=NMR)-Spektroskopie, wird dazu eingesetzt, die chemische Zusammensetzung von Proben zu bestimmen. Besonders wird dabei der hohe mögliche Automatisierungsgrad und die schnelle Erhältlichkeit von Messergebnissen geschätzt. Die instrumentelle Analytik mit einem hohen Automatisierungsgrad wird beispielsweise bei so genannten Reihenuntersuchungen eingesetzt, bei denen eine Vielzahl von ähnlichen Proben, insbesondere von biologischen Proben, in gleicher Weise untersucht werden sollen.

Ziel ist dabei die Automatisierung der Probenbereitstellung (etwa das Befüllen von Probengefäßen mit Probensubstanz) und der Beschickung der Messapparatur (etwa das Überführen eines Probengefäßes an die Messposition in der Messapparatur und zurück), sowie die automatische Auswertung der Messergebnisse.

In der Probenbereitstellung und in der Beschickung der Messapparatur ist es bekannt, Probengestelle einzusetzen, die Halterungen für eine Vielzahl von Messproben aufweisen. Die einzelnen Probengefäße in den definierten Positionen der Halterungen können mit Hilfe von Robotern gehandhabt werden. Ein Beispiel für einen Probenroboter zur Beschickung ist der "SampleJet" der Firma Bruker BioSpin. Der Greifer eines Roboters setzt dabei typischerweise an einer Kappe des Probengefäßes an, um die Bruchgefahr zu reduzieren.

Die Handhabung der Probengefäße wird erleichtert, wenn die Probengefäße schon vor bei der Probenbereitstellung mit Kappen versehen sind. In diesem Fall muss die Befüllung der Probengefäße durch eine Bohrung der Kappen erfolgen. Kappen mit einer solchen Bohrung sind beispielsweise aus der DE 20 2007 001 251 U1 bekannt geworden. Falls die Probensubstanz flüchtige Lösungsmittel enthält, sollte das Probengefäß nach dem Befüllen dicht verschlossen werden, um einem Abdampfen von Lösungsmittel und damit einer Veränderung der Probe vorzubeugen.

Das Verschließen von Probengefäßen, die Kappen mit einer Bohrung aufweisen, ist jedoch operativ schwierig, und insbesondere schwierig in eine automatisierte Probenbereitstellung zu integrieren.

Die DE 203 14 517 U1 beschreibt ein NMR-Spektrometer mit Greifvorrichtung zur Handhabung einer Probenhülse mit Außennut. Mit einem Greifer werden Probengefäße gehandhabt, welche mittels einer übergestülpten Kappe verschlossen sind, wobei in eine Bohrung der Kappe ein Verschlusskügelchen einführbar ist. Die mit der Kappe versehenen Probengefäße können in einem Probengestell gelagert werden.

### Aufgabe der Erfindung

Aufgabe der vorliegenden Erfindung ist es, den Verschluss von Probengefäßen, die eine Kappe mit Bohrung aufweisen, im Rahmen einer automatisierten Probenbereitstellung zu erleichtern.

### Kurze Beschreibung der Erfindung

Diese Aufgabe wird gelöst durch ein System der eingangs genannten Art, das dadurch gekennzeichnet ist,
dass die Probengefäße jeweils eine Kappe aufweisen, die über das offene Ende des Probengefäßes gestülpt ist, wobei die Kappe eine Bohrung aufweist, durch die das Innere des Probengefäßes zugänglich ist,
dass das Probengestell eine abnehmbare Deckelplatte aufweist, deren Unterseite im aufgesetzten Zustand der Deckelplatte den Kappen der Probengefäße zugewandt ist,
und dass die Deckelplatte an der Oberseite für jede Halterung eine näherungsweise trichterförmige Senke aufweist, in deren Mitte eine Durchbruchöffnung durch die Deckelplatte vorgesehen ist, wobei die Durchbruchöffnung bei aufgesetzter Deckelplatte mit der Bohrung einer Kappe eines darunter gehaltenen Probengefäßes fluchtet, und wobei die Durchbruchöffnungen ausreichend groß sind, so dass die Verschlusskügelchen die Durchbruchöffnung passieren können.

Im Rahmen der vorliegenden Erfindung werden Probengefäße im Probengestell für eine automatische Handhabung durch Roboter, insbesondere den "SampleJet" der Firma Bruker BioSpin, bereitgestellt. Die Halterungen sind wohl definiert, beispielsweise gemäß dem 96er well plate Standard, räumlich angeordnet. Die in den Halterungen angeordneten Probengefäße weisen eine Kappe mit Bohrung auf, durch die die Probengefäße befüllt werden können, beispielsweise mit einer Injektionsnadel. Beim Befüllen der Probengefäße kann die Deckelplatte des Probengestells abgenommen werden, um den Zugang zu den Probengefäßen für einen befüllenden Roboter zu erleichtern (alternativ kann aber auch eine Befüllung durch die Durchbruchöffnungen der Deckelplatte erfolgen). Nach Abschluss der Befüllung der Probengefäße werden diese verschlossen.

Zum Verschließen der Probengefäße im Rahmen der Erfindung wird die Deckelplatte aufgesetzt. Sodann werden Verschlusskügelchen außen (auf der Oberseite) auf der Deckelplatte verteilt. Durch die trichterförmigen Senken rollen die Verschlusskügelchen von selbst in die Durchbruchöffnungen der Deckelplatte hinein. Bevorzugt reicht die Tiefe der Durchbruchöffnungen nur jeweils für die Aufnahme eines einzigen Verschlusskügelchens aus; anderenfalls kann auch bei der Verteilung der Verschlusskügelchen darauf geachtet werden, nur jeweils ein Verschlusskügelchen in jede Senke einzulegen. Durch die Senke und die Durchbruchöffnung wird das Verschlusskügelchen automatisch bezüglich der oberen Öffnung einer Bohrung einer Kappe eines darunter gehaltenen Probengefäßes ausgerichtet. In der Regel liegen die Verschlusskügelchen dann an der oberen Öffnung der Bohrung der kappe an.

Es ist sodann sehr einfach, das ausgerichtete Verschlusskügelchen noch in die Bohrung hinein zu drücken, um diese zu verschließen. Man beachte, dass dazu das Kappenmaterial (in der Regel ein Kunststoff) in aller Regel elastisch verformt wird, wodurch sich auch ein dichter Sitz des Verschlusskügelchens ergibt. Das Eindrücken des Verschlusskügelchens kann mit einem Stempel erfolgen, der einen geringfügig geringeren Durchmesser aufweist als die Durchbruchöffnung. Der Stempel wird dabei durch die Durchbruchöffnung und die trichterförmige Senke geführt. Im einfachsten Fall wird der Stempel manuell eingesetzt; alternativ kann aber auch ein Roboter diesen Schritt durchführen.

Nach Verschluss der Probengefäße befinden sich die Verschlusskügelchen in den Bohrungen der Kappen. Die Verschlusskügelchen verhindern ein Verdampfen von flüchtigen Bestandteilen von in den Probengefäßen enthaltener Probensubstanz, und verhindern gleichzeitig den Eintrag von Verunreinigungen in die Probensubstanz.

Durchbruchöffnung und Bohrung sind typischerweise im Querschnitt kreisförmig ausgebildet. Das Verschlusskügelchen ist aus einem gegenüber der Probensubstanz und deren Lösungsmittel resistenten Material ausgebildet; in fast allen Fällen können Glas- oder Keramik-Kügelchen eingesetzt werden, es sind aber auch Kunststoff-Kügelchen denkbar. Der typische Durchmesser eines Verschlusskügelchens beträgt ca. 1-5 mm, bevorzugt 3 mm. Als Probengefäße werden typischerweise im Wesentlichen kreiszylindermantelförmige, unten geschlossene Glasröhrchen mit Außendurchmesser 1-5 mm eingesetzt.

Durch die erfindungsgemäße Ausbildung des Probengestells, insbesondere der Deckelplatte, wird der Verschluss der Probengefäße, genauer das Einbringen von Verschlusskügelchen in die Bohrungen der Kappen, erheblich erleichtert. Das Verschließen erfolgt erfindungsgemäß in einem Probengestell, welches für die Probenbereitstellung und Beschickung der Messapparatur ohnehin eingesetzt wird, wodurch Probengefäßüberführungen zwischen verschiedenen Probengestellen (Probenhaltern) vermieden werden. Somit ist auch eine gute Integration in die automatisierte Probenhandhabung gegeben.

### Bevorzugte Ausführungsformen der Erfindung

Bevorzugt ist eine Ausführungsform des erfindungsgemäßen Systems, bei der an der Unterseite der Deckelplatte Nocken vorgesehen sind, mit denen die Probengefäße im aufgesetzten Zustand der Deckelplatte ausgerichtet werden, insbesondere wobei je Probengefäß vier Nocken vorgesehen sind, die an der Kappe eines jeden Probengefäßes angreifen. Die Nocken sind im einfachsten Fall kreisförmig ausgebildet, können aber auch an die Außenkontur der Kappen besonders angepasst sein. Die Nocken können insbesondere in "Zwickeln" (Zwischengitterplätzen des Probengefäßgitters) angeordnet sein. Die Nocken sichern (bei aufgesetzter Deckelplatte, also geschlossenem Deckel) die Position eines jeden Probengefäßes bei Überführung des Probengestells gegen ein Verschieben, insbesondere wenn das Probengestell verschwenkt wird.

Besonders bevorzugt ist eine Ausführungsform, die dadurch gekennzeichnet ist, dass das Probengestell eine obere Halteplatte aufweist, die Ausnehmungen für die Probengefäße aufweist, wobei der Durchmesser der Ausnehmungen größer ist als der Durchmesser der Probengefäße, aber kleiner ist als der Außendurchmesser der Kappen, und dass die Probengefäße in die obere Halteplatte eingehängt sind, wobei die Kappen auf der Halteplatte aufliegen. Die Probengefäße (Probenröhrchen) hängen normalerweise senkrecht nach unten durch die Ausnehmungen (Löcher) der oberen Halteplatte. Die Kappe liegt an der Halteplatte auf, wobei die Kappe auch in die Ausnehmung (das Loch) hinein ragen kann (die Kappe muss also nur größer sein als der kleinste Durchmesser der Ausnehmung). Bei dieser Ausführungsform wird eine Auflage des Probengefäßes selbst, etwa dessen unteren Endes auf einer Bodenplatte des Probengestells, vermieden. Dies reduziert die Gefahr von Glasbruch beim Probengefäß, sowohl bei Erschütterungen des Probengestells, als auch bei der Handhabung einzelner Probengefäße durch Roboter. Die Ausnehmungen (Löcher) der Halteplatte können in kurze Rohrabschnitte übergehen. Die genaue Form der Ausnehmungen ist bevorzugt an die Gestalt der Kappen angepasst, wobei die Kappen auch teilweise in die Durchbruchöffnung hineinragen können.

Bevorzugt ist weiterhin eine Ausführungsform, bei der das Probengestell einen nach unten offenen Bodenbereich aufweist. Dadurch ist es möglich, einen Kühlblock in das Probengestell von unten einzuführen, um die Probengefäße bzw. enthaltene Probensubstanz zu kühlen. Das Einführen des Kühlblocks von unten erfolgt dabei parallel zur Erstreckungsrichtung der (typischerweise gerade nach unten hängenden) Probengefäße.

Bei einer ebenfalls bevorzugten, alternativen Ausführungsform weist das Probengestell eine Bodenplatte auf, die mehrere Löcher aufweist. Die Bodenplatte sorgt für einen gewissen Schutz der Probengefäße, etwa bei einem Transport des Probengestells, gestattet aber gleichzeitig einen Zugang zu den gehaltenen Probengefäßen von unten, etwa zu Kühlzwecken mit Kühlfingern oder gekühltem Gasstrom.

Eine besonders bevorzugte Weiterbildung dieser Ausführungsform sieht vor, dass die Löcher in der Bodenplatte auf Zwischenräume zwischen gehaltenen Probengefäßen ausgerichtet sind, insbesondere wobei jede Halterungsposition von vier Löchern umgeben ist. Durch die Löcher sind Kühlfinger (etwa metallische Stäbe oder Rohre) in die Umgebung der Probengefäße einführbar, mittels denen die Probensubstanz in den Probengefäßen gekühlt werden kann. Die Kühlfinger verlaufen dabei parallel zur Erstreckungsrichtung der Probengefäße, und werden parallel zu dieser Erstreckungsrichtung ein- und ausgeführt.

Eine ganz besonders bevorzugte Ausführungsform des erfindungsgemäßen Systems sieht vor, dass das Probengestell zusammengesetzt ist aus
- einem Gestell-Unterteil, welches die gehaltenen Probengefäße in einem unteren Bereich der Probengefäße zumindest seitlich umgibt,
- einem Gestell-Oberteil, welches die gehaltenen Probengefäße in einem oberen Bereich der Probengefäße zumindest seitlich umgibt und die obere Halteplatte enthält,
- und einem Deckel, welcher die Deckelplatte enthält,
wobei das Gestell-Unterteil mit dem Gestell-Oberteil verklemmbar ist,
und wobei der Deckel mit dem Gestell-Oberteil verklemmbar ist. Durch diesen Aufbau ist das Probengestell besonders einfach zu fertigen und zusammenzusetzen, und auch zu handhaben. Die Verklemmung zwischen Gestell-Unterteil und Gestell-Oberteil ist im einfachsten Fall irreversibel, kann aber auch klemm- und wiederlösbar ausgebildet sein. Die Verklemmung zwischen Deckel und Gestell-Oberteil ist grundsätzlich lösbar, um bei gelöstem (abgenommenem) Deckel einen Zugang zu den Probengefäßen zum Zwecke des Verbringens der Probengefäße in eine Messapparatur (und in der Regel auch zurück) zu ermöglichen. Die Verklemmung zwischen Deckel und Gestell-Oberteil ist im aufgesetzten (verklemmten) Zustand des Deckels bevorzugt so fest, dass das Probengestell am Deckel (bzw. an einem Eingriff zwischen Deckel und Gestell-Oberteil) getragen werden kann.

Bevorzugt ist weiterhin eine Ausführungsform, bei der ein Zwischenboden vorgesehen ist, der Ausnehmungen für die Probengefäße zum Ausrichten der Probengefäße aufweist, und der von der oberen Halteplatte beabstandet ist, insbesondere wobei für den Abstand AB von oberer Halteplatte und Zwischenboden und die Länge L der Probengefäße gilt: AB≥0,25*L. Mit dem Zwischenboden bzw. den dortigen Ausnehmungen (Löchern) werden die Probengefäße auf eine vertikale Achse positioniert und gesichert. Insbesondere kann mit dem Zwischenboden ein Aneinanderschlagen von Probengefäßen oder ein Verkanten der Probengefäße verhindern. Dadurch wird auch Glasbruch verhindert, wenn ein Kühlblock oder Kühlfinger von unten in das Probengestell eingeschoben werden sollen. Der Durchmesser der Ausnehmungen (Löcher) des Zwischenbodens sollte nur minimal größer sein als der Außendurchmesser der Probengefäße, beispielsweise mit maximal 10% Spiel (=Unterscheid der Durchmesser). Der vorgegebene Mindest-Abstand AB begrenzt das Spiel der Probengefäße im Bereich ihres unteren Endes.

Bevorzugt ist auch eine Weiterbildung der vorhergehenden beiden Ausführungsformen, bei der der Zwischenboden zwischen Gestell-Oberteil und Gestell-Unterteil einsetzbar ist, insbesondere wobei Vorsprünge zur Auflage des Zwischenbodens im oberen Bereich des Gestell-Unterteils ausgebildet sind. Dies vereinfacht wiederum die Fertigung und den Zusammenbau des Probengestells des erfindungsgemäßen Systems. Außerdem kann der Zwischenboden leichter ausgetauscht werden, etwa zur Anpassung an verschiedene Probengefäßdurchmesser.

Besonders bevorzugt ist schließlich eine Ausführungsform, bei der die Halterungen der Probengefäße gemäß dem "96er well plate"-Standard angeordnet sind. Der Standard sieht eine 8x12-Anordnung von Probenpositionen in definierten Abständen vor. Diese Definitionen erleichtern die Steuerung und damit den Zugriff durch einen Roboter auf die Probenpositionen.

In den Rahmen der vorliegenden Erfindung fällt auch die Verwendung eines erfindungsgemäßen Systems zum Verschließen von Probengefäßen mit Verschlusskügelchen, wobei Verschlusskügelchen auf der aufgesetzten Deckelplatte verteilt werden, und wobei jeweils ein in eine Durchbruchöffnung gerolltes Verschlusskügelchen durch die Durchbruchöffnung in die Bohrung einer Kappe eines darunter gehaltenen Probengefäßes eingedrückt wird, insbesondere manuell mittels eines Stempels. Bei der erfindungsgemäßen Verwendung werden die selbstführenden Eigenschaften der trichterförmigen Senken der Deckelplatte genutzt, um die Positionierung der Verschlusskügelchen und den Verschluss der Kappen vorzubereiten und zu erleichtern. Man beachte, dass durch die Durchbruchöffnungen in der Deckelplatte der Stempel geführt wird, was den Verschluss der Kappen zusätzlich erleichtert.

Die Erfindung umfasst weiterhin die Verwendung eines erfindungsgemäßen Systems zur Probenpräparation und/oder Probenbereitstellung für Kernspinresonanz (=NMR)-Messungen, insbesondere wobei die Probengefäße als NMR-Probenröhrchen ausgebildet sind. Für die Durchführung von Reihenuntersuchungen im Rahmen der NMR-Spektroskopie hat sich das erfindungsgemäße System in der Praxis besonders bewährt. Insbesondere kann die Beschickung eines NMR-Spektrometers mit einem Probengestell des erfindungsgemäßen Systems (d.h. von einem Probengestell aus) erfolgen.

Weiterhin umfasst die Erfindung die Verwendung eines erfindungsgemäßen Systems zur Kühlung von Probensubstanz in den Probengefäßen. Diese Verwendung kann besonders gut bei hängenden Probengefäßen eingesetzt werden, wobei am Probengestell ein Kühlzugang bevorzugt über den Bodenbereich eingerichtet ist. Der Boden wird bei hängenden Proben zur Probenpositionierung nicht benötigt. Bevorzugt erfolgt bei der Kühlung dabei für den Wärmeabfluss an den Probengefäßen keine Wärmeleitung durch die Gestellwand, und die Kühlung erfolgt bevorzugt mechanisch entkoppelt vom Probengestell.

Man beachte, dass die vorgenannten Verwendungen erfindungsgemäß auch miteinander kombiniert werden können.

Eine bevorzugte Variante der letztgenannten Verwendung mit einem Probengestell mit unten offenem Bodenbereich sieht vor, dass durch den unten offenen Bodenbereich ein näherungsweise quaderförmiger Kühlblock in das Probengestell eingeschoben wird, welcher Bohrungen aufweist, in die die gehaltenen Probengefäße eingeführt werden, und dass der Kühlblock auf eine vorgegebene Temperatur, insbesondere um -196°C oder weniger, gekühlt ist. Der Kühlblock ist einfach zu fertigen und einfach zu handhaben, und gestattet eine sehr hohe Kühlleistung. Die vorgegebene Temperatur wird entsprechend den Proben- und Materialanforderungen gewählt.

Eine weitere Variante der letztgenannten Verwendung mit einem Probengestell mit Löchern in der Bodenplatte ist dadurch gekennzeichnet, dass durch einen Teil der Löcher in der Bodenplatte ein kühlender Gasstrom eingeblasen wird, und dass durch einen Teil der Löcher in der Bodenplatte der kühlende Gasstrom ausströmt. Diese Art der Kühlung ist besonders einfach zu realisieren.

Eine weitere, bevorzugte Variante der letztgenannten Verwendung mit einem Probengestell mit gegenüber den Probenpositionen versetzten Löchern in der Bodenplatte sieht vor, dass durch die Löcher in der Bodenplatte Kühlfinger in das Probengestell eingeschoben werden, die zwischen die gehaltenen Probengefäße eingreifen, insbesondere wobei die Kühlfinger die Probengefäße nicht berühren, und dass die Kühlfinger auf eine vorgegebene Temperatur, insbesondere um -196°C oder weniger, gekühlt sind. Mit den Kühlfingern kann eine sehr gleichmäßige Kühlung der Probengefäße erreicht werden, und es ist eine einfache mechanische Entkopplung der Kühlung vom Probengestell möglich. Die vorgegebene Temperatur wird entsprechend den Proben- und Materialanforderungen gewählt.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Die Erfindung ist in der Zeichnung dargestellt und wird anhand von Ausführungsbeispielen näher erläutert. Es zeigen:
- Fig.1a-1d: eine schematische Explosions-Darstellung eines Probengestells für ein erfindungsgemäßes System, mit Deckel (Fig. 1a), Gestell-Oberteil (Fig. 1b), Zwischenboden (Fig. 1c) und Gestell-Unterteil (Fig. 1d);
- Fig. 2: eine perspektivische Ansicht des Gestell-Unterteils von Fig. 1d von schräg unten;
- Fig. 3a: eine schematische perspektivische Ansicht des zusammengebauten Probengestells von Fig. 1, eingestellt in eine Kühlvorrichtung mit Kühlfingern;
- Fig. 3b: eine schematische perspektivische Ansicht der Kühlvorrichtung mit Kühlfingern von Fig. 3a allein;
- Fig. 4: eine schematische Querschnittsansicht durch ein erfindungsgemäßes System, mit dem Probengestell eingestellt in die Kühlvorrichtung mit Kühlfingern, von Fig. 3b;
- Fig. 5: einen Detailausschnitt von Fig. 4 im Bereich der Kappen der eingehängten Probengefäße;
- Fig. 6: einen Detailausschnitt aus Fig. 5 im Bereich der Bohrung einer Kappe, mit einem Stempel zum Positionieren eines Verschlusskügelchens;
- Fig. 7: eine schematische Darstellung einer alternativen Ausgestaltung einer Senke in der Deckelplatte;
- Fig. 8: eine schematische Querschnittsansicht eines erfindungsgemäßen Systems umfassend ein Probengestell, mit eingeschobenem Kühlblock.

Die vorliegende Erfindung betrifft ein System mit einem Probengestell (oder einem Probenhalter) für die Bereitstellung von Probengefäßen, insbesondere NMR-Probenröhrchen, für eine weitgehend automatische Handhabung der Probengefäße und darin enthaltener Probensubstanz in der instrumentellen Analytik, insbesondere der NMR-Spektroskopie.

Das erfindungsgemäße System ist besonders einfach und kostengünstig zu fertigen, so dass es auch für den Einweg-Gebrauch gut einsetzbar ist. Als Material für das Probengestell ist insbesondere umweltverträgliches Polycarbonat geeignet; bevorzugt ist das Material des Probengestells auch transparent oder zumindest durchscheinend, um die Befüllung des Probengestells leicht von außen visuell prüfen zu können.

Das Probengestell wird üblicherweise voll besetzt mit Probengefäßen bereitgestellt (das Probengestell agiert somit auch als Verpackung für Probengefäße). Sodann werden die Probengefäße mit Probensubstanz gefüllt und (in der Regel) verschlossen. Dabei werden Verschlusskügelchen eingesetzt, die durch die erfindungsgemäße Gestaltung der Deckelplatte besonders leicht in Bohrungen von Verschlusskappen der Probengefäße einführbar sind. Gegebenenfalls nach einer Zwischenlagerung des Probengestells werden die Probengefäße sodann an eine Messapparatur, etwa ein NMR-Spetrometer, verbracht (übergeben) und vermessen. Probengefäßübergabe und Vermessung erfolgen typischerweise für jedes Probengefäß einzeln und nacheinander. Nach der Messung werden die Probengefäße typischerweise in das Probengestell zurückgestellt, und nach Vermessung aller Probengefäße wird das gesamte Probengestell typischerweise entsorgt. Alternativ können auch nur die vermessenen Probengefäße entsorgt werden, und das Probengestell kann mit leeren (unbenutzten) Probengefäßen neu befüllt werden.

Die Handhabung der Probengefäße und bevorzugt auch die Befüllung mit Probensubstanz erfolgt erfindungsgemäß automatisch mittels eines Roboters; das Probengestell des erfindungsgemäßen Systems dient als Automatisierungs-Rack.

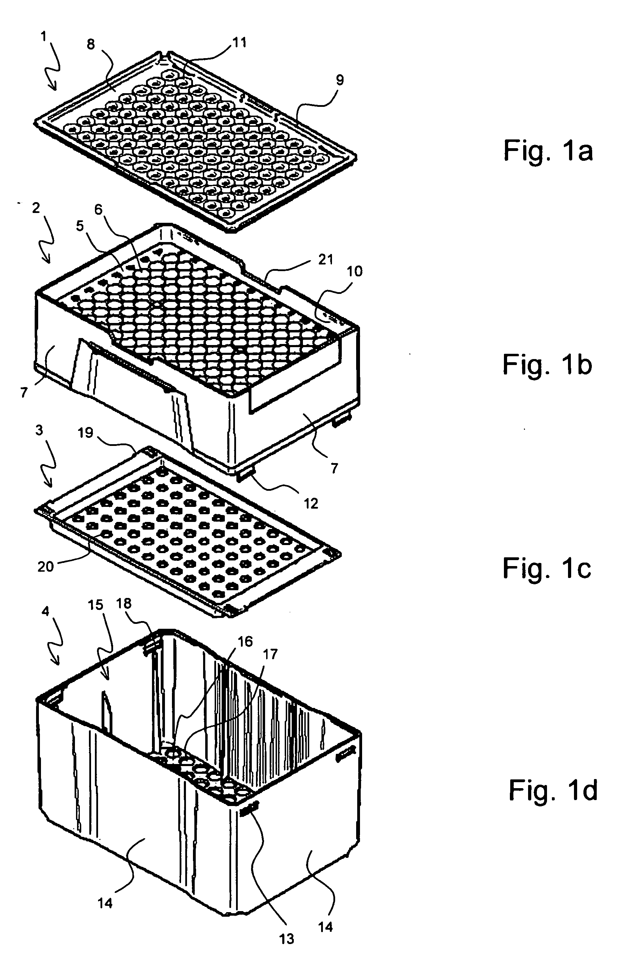

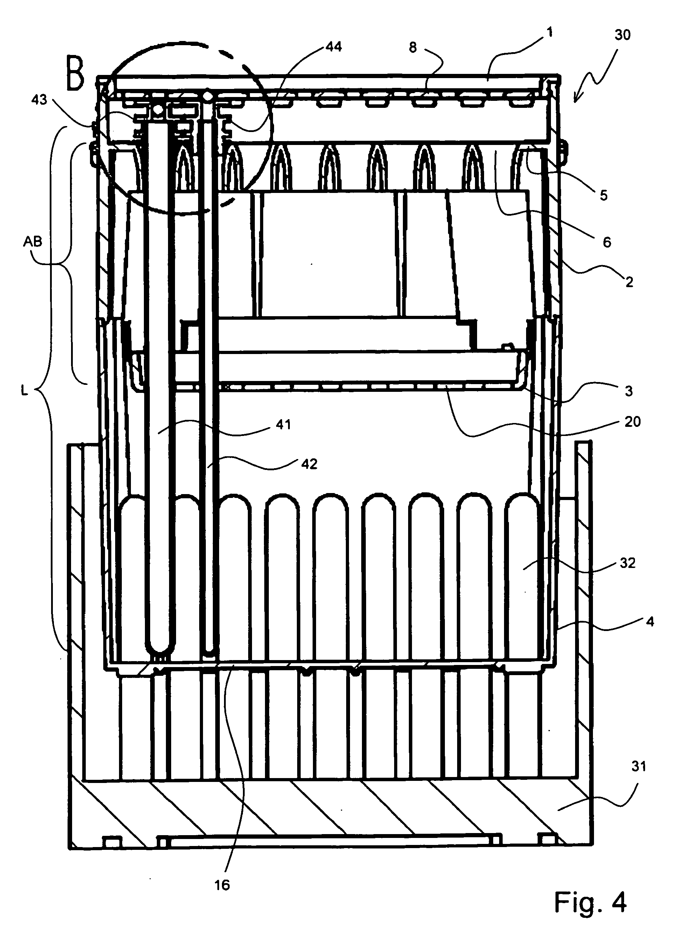

Die **Figuren 1a-1d** zeigen eine Ausführungsform eines Probengestells für ein erfindungsgemäßes System, wobei das Probengestell (hier) aus vier Einzelteilen zusammengesetzt werden kann. Das Probengestell umfasst einen Deckel 1, ein Gestell-Oberteil 2, einen Zwischenboden 3 und ein Gestell-Unterteil 4. In den Figuren 1a-1d nicht gezeigt sind Probengefäße, die im Probengestell angeordnet werden können (siehe dazu Fig. 4).

Die Halterungen für Proben sind im Wesentlichen durch das Gestell-Oberteil 2 ausgebildet. Dieses umfasst eine obere Halteplatte 5, in der eine Vielzahl von Ausnehmungen (Löchern) 6 ausgebildet ist. An der in Fig. 1b nicht sichtbaren Unterseite der Halteplatte 5 können die Ausnehmungen in kurze Rohrabschnitte übergehen. Die Ausnehmungen 6 können trichterförmig angeschrägt sein, um das Einführen von Probengefäßen zu erleichtern. In die Ausnehmungen 6 werden Probengefäße an ihren Kappen eingehängt (nicht dargestellt, vgl. Fig. 4). Die Ausnehmungen 6 markieren in so weit auch Positionen für zu haltende Probengefäße (wobei hier die Probenpositionen in einer horizontalen Ebene ein quadratisches Gitter ausbilden). Im gezeigten Ausführungsbeispiel sind Halterungen bzw. Positionen für 96 Probengefäße (in 8x12-Anordnung, entsprechend dem 96er well plate Standard) vorgesehen. Das Gestell-Oberteil 5 verfügt über seitliche Außenwände 7, die den Innenraum des Gestell-Oberteils 2 seitlich umschließen. An den Außenwänden 7, insbesondere an deren Oberkanten, können Eingriffsmöglichkeiten 21 vorgesehen sein.

Auf das Gestell-Oberteil 2 ist oben der Deckel 1 aufsetzbar und abnehmbar. Der Deckel 1 ist typischerweise einstückig ausgebildet und verfügt über eine Deckelplatte 8 und einen Deckelrahmen 9. Der Deckel 1 kann mit Klemmmitteln, etwa Einkerbungen 10 am Gestell-Oberteil 2 und Vorsprüngen (nicht dargestellt) am Deckelrahmen 9, am Gestell-Oberteil 2 eingerastet (verklemmt) und manuell wieder gelöst werden. Die Deckelplatte 8 verfügt über eine Vielzahl von trichterförmigen Senken 11, die in ihrem Zentrum jeweils in eine Durchbruchöffnung durch die Deckelplatte 8 übergehen. Bei aufgesetztem Deckel 1 fluchtet jeweils eine Senke 11 bzw. zugehörige Durchbruchöffnung der Deckelplatte 1 mit einer Ausnehmung 6 der oberen Halteplatte 5.

Unten am Gestell-Oberteil 2 sind Klemmbacken 12 ausgebildet, mit denen das Gestell-Oberteil 2 mit dem Gestell-Unterteil 4 verklemmt werden kann. Dazu greifen die Klemmbacken 12 in Ausnehmungen 13 am Gestell-Unterteil 4 ein. Das Gestell-Unterteil 4 weist Seitenwände 14 auf, die einen Raum 15 für die Probengefäße umschließen. In der gezeigten Ausführungsform weist das Gestell-Unterteil 4 weiterhin eine Bodenplatte 16 auf, in der Löcher 17 für einzuschiebende Kühlfinger einer Kühlvorrichtung ausgebildet sind. Die Löcher 17 sind gegenüber den Positionen für gehaltene Probengefäße versetzt und bilden ein ebenes, quadratisches Gitter aus.

In das Gestell-Unterteil 4 ist ein Zwischenboden 3 einlegbar. An der Innenseite der kurzen Seitenwände 14 des Gestell-Unterteils 4 sind dazu Vorsprünge 18 ausgebildet, auf die Laschen 19 des Zwischenbodens 3 aufgelegt (und mittels der Klemmbacken 12 zusätzlich vertikal fixiert) werden. Im Zwischenboden 3 sind Ausnehmungen (Löcher) 20 ausgebildet, durch die Probengefäße durchgeführt und werden, wodurch die Probengefäße lateral mit wenig Spiel fixiert werden. Letzteres verhindert ein Aneinanderschlagen und Verkanten von Probengefäßen vor allem bei abgenommenem Deckel (welcher über Nocken die Probengefäße zu sichern vermag).

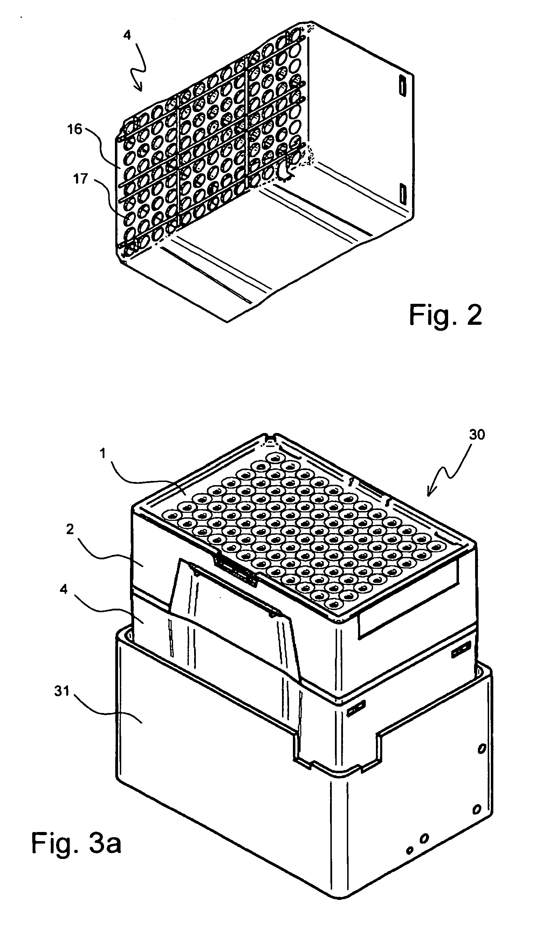

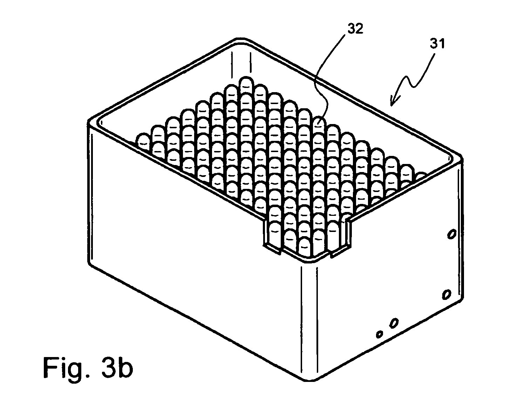

Die **Figur 2** zeigt das Gestell-Unterteil 4 von Fig. 1d in einer Perspektive von schräg unten. Die Löcher 17 bilden ein (ebenes) quadratisches Gitter, dass dem Gitter der Probenpositionen entspricht, jedoch eine Reihe und eine Spalte mehr umfasst und um je eine halbe Gitterperiode in beide Gitterrichtungen versetzt ist. Insgesamt sind somit 9x13 Löcher 17 vorgesehen, wobei jede Probenposition unmittelbar von vier Löchern 17 umgeben ist. Durch die Löcher 17 können Kühlfinger zwischen im Probengestell gehaltene Probengefäße eingeschoben werden (vgl. Fig. 3b, Fig. 4).

**Figur 3a** zeigt ein Probengestell 30 für ein erfindungsgemäßes System in zusammengebautem Zustand, mit im Gestell-Oberteil 2 eingesetztem (geschlossenem und verklemmtem) Deckel 1 und am Gestell-Oberteil 2 verklemmtem Gestell-Unterteil 4. Der eingelegte Zwischenboden ist in der Abbildung verdeckt. Das Probengestell 30 ist in eine Kühlvorrichtung 31 eingestellt, die mit Kühlfingern 32 durch die Löcher in der Bodenplatte des Gestell-Unterteils 4 ragt. Die Kühlvorrichtung 31 ohne Probengestell ist in Figur 3b dargestellt, in der auch die Kühlfinger 32 gut zu sehen sind. Die Anzahl und Anordnung der Kühlfinger 32 entspricht der Anzahl und Anordnung der Löcher in der Bodenplatte. In der gezeigten Ausführungsform sind somit 9x13 Kühlfinger 32 vorgesehen. Der Wärmeübertrag zwischen Kühlfingern 32 und Probengefäßen erfolgt mittels Strahlung und zum Teil durch Konvektion. Figur 4 zeigt das erfindungsgemäße System mit dem Probengestell 30 in schematischer Querschnittsansicht, mit durch die Bodenplatte 16 eingeschobenen Kühlfingern 32 einer Kühlvorrichtung 31.

In den Ausnehmungen (Löchern) 6 der Halteplatte 5 werden Probengefäße gehalten, hier sind beispielhaft zwei Probengefäße 41, 42 gezeigt (bevorzugt ist das Probengestell vollständig mit gleichartigen Probengefäßen besetzt; es ist aber erfindungsgemäß auch eine nur teilweise Besetzung des Probengestells mit Probengefäßen möglich). Die Probengefäße 41, 42 sind als näherungsweise zylinderförmige Glasröhrchen ausgebildet, die unten ein geschlossenes Ende und oben ein offenes Ende aufweisen. Das linke Probengefäß 41 weist einen Außendurchmesser von 5 mm auf, das rechte Probengefäß 42 einen Außendurchmesser von 3mm. Die Probengefäße 41, 42 durchragen jeweils ihre Ausnehmung 6; der Außendurchmesser der Probengefäße 41, 42 ist kleiner als der kleinste Innendurchmesser (am unteren Bereich) der Ausnehmungen 6. Über das jeweils obere Ende der Probengefäße 41, 42 ist eine Kappe 43, 44 gestülpt (aufgepresst), die ein Durchrutschen der Probengefäße 41, 42 durch die Ausnehmungen 6 verhindert (vgl. dazu Fig. 4b). Die Kappen 43, 44 sind im Wesentlichen zwischen der Halteplatte 5 und der Deckelplatte 8 des Deckels 1 eingeklemmt.

Die Ausnehmungen (Löcher) 20 des Zwischenbodens 3 werden von den Probengefäßen 41, 42 durchragt. Vorliegend ist der Zwischenboden 3 auf den größeren Durchmesser des linken Probengefäßes 41 abgestimmt, denn dieses Probengefäß 41 passt mit nur wenig Spiel noch durch die zugehörige Ausnehmung 20. Da der Abstand AB zwischen oberer Halteplatte 5 und dem Zwischenboden 3 (gemessen zwischen den jeweiligen Anlagepunkten der Kappe bzw. Probengefäßes) einen erheblichen Anteil, hier ca. die Hälfte, der Gesamtlänge L des Probenröhrchens 41 ausmacht, hat auch das untere Ende des Probengefäßes 41 nur wenig laterales (seitliches) Spiel.

Man beachte, dass die Probengefäße 41, 42 mit ihren unteren Enden nicht auf der Bodenplatte 16 aufliegen, sondern frei hängen und insbesondere auch nicht die versetzt angeordneten Kühlfinger 32 berühren. Wärmeaustausch kann unmittelbar über Strahlung (und ergänzend durch lokale Gaskonvektion) zwischen den Kühlfingern 32 und den Probengefäßen 41, 42 erfolgen. Bevorzugt berühren sich Kühlvorrichtung 31 und Probengestell 30 (einschließlich Probengefäßen 41, 42) gar nicht, so dass eine vollständige mechanische Entkopplung von Probenhalterung und Kühlung erreicht wird. Die Kühlvorrichtung 31 wird in nicht näher dargestellter Weise aktiv gekühlt, etwa mittels einer Wärmepumpe; bei kurzen Lagerzeiten kann alternativ auch die Kühlleistung durch die Wärmekapazität einer vorgekühlten Kühlvorrichtung 31 aufrecht erhalten werden.

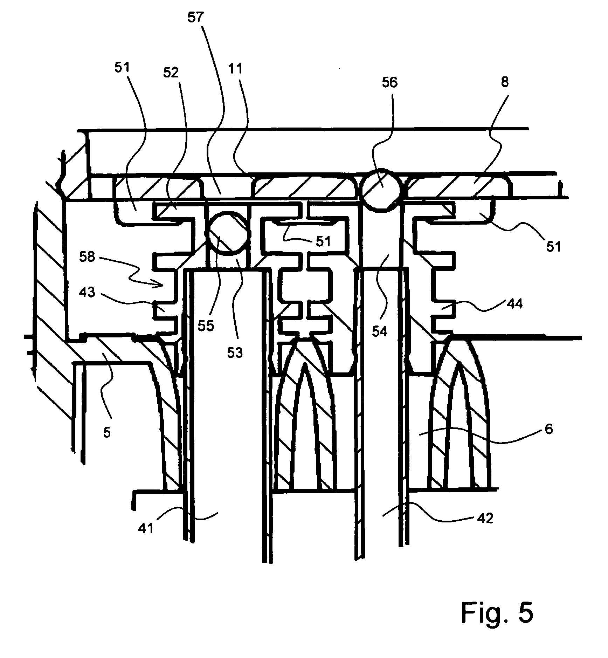

**Figur 5** zeigt den mit "B" markierten Ausschnitt aus Fig. 4 in einer Vergrößerung. Über die oberen Enden der Probengefäße 41, 42 sind jeweils Kappen 43, 44 gestülpt. Die Kappen 43, 44 besitzen jeweils einen deutlich größeren maximalen (Außen-)Durchmesser als die Probengefäße 41, 42; der maximale Außendurchmesser der Kappen 43, 44 ist auch größer als der (minimale) Innendurchmesser der Ausnehmungen (Löcher) 6 der Halteplatte 5. Der Außendurchmesser der Probengefäße 41, 42 ist wiederum kleiner als der kleinste Innendurchmesser der Ausnehmungen 6. Daher hängen (der Schwerkraft folgend) die Probengefäße 41, 42 an ihren Kappen 43, 44 durch die Ausnehmungen 6 nach unten hindurch; die Kappen 43, 44 liegen von oben an der Halteplatte 5 auf, wobei die Kappen 43, 44 teilweise auch in die Ausnehmungen 6 hinein ragen. Letzteres bewirkt eine gewisse Zentrierung der Probengefäße 41, 42 an ihren Haltepositionen. Eine weitere Zentrierung wird durch Nocken 51 bewirkt, die an der Unterseite der Deckelplatte 8 ausgebildet sind. Die Nocken 51 sichern lateral den oberen Teil (Kragenbereich) 52 der Kappen 43, 44.

Die Kappen 43, 44 weisen je eine Bohrung 53, 54 auf, durch die das innere der Probengefäße 41, 42 von oben zugänglich ist, solange nicht durch ein Verschlusskügelchen 55, 56 der Zugang blockiert ist. An den Kappen 43, 44 sind außerdem ringförmige Ausnehmungen 58 ausgebildet, die den Eingriff eines Greifers eines Roboters erleichtern (nicht dargestellt). Die Probengefäße 41, 42 können problemlos über die fest sitzenden Kappen 43, 44 gehandhabt werden. Die Kappen 43, 44 können insbesondere wie in der DE 20 2007 001 251 U1 beschreiben ausgebildet sein.

Die Bohrungen 53, 54 der Kappen 43, 44 sind jeweils direkt unterhalb einer Senke 11 der Deckelplatte 8 und einer Durchbruchöffnung 57, in die die Senke 11 übergeht, angeordnet (insbesondere auch ohne nennenswerten vertikalen Abstand; der Abstand zwischen der Unterkante der Deckelplatte 8 und dem oberen Rand der Kappe 43, 44 ist erfindungsgemäß kleiner als der Durchmesser eines Verschlusskügelchens 55, 56). Ein auf die Deckelplatte 8 aufgelegtes Verschlusskügelchen rollt in Folge von Schwerkraft in der Senke 11 in eine Durchbruchöffnung hinein (vgl. Verschlusskügelchen 56), d.h. es findet von selbst seinen Weg, und liegt anschließend an der Oberkante einer Bohrung an (vgl. Bohrung 54). Die Durchbruchöffnung 57 ist dabei ausreichend weit, um das Verschlusskügelchen 55, 56 passieren zu lassen. Aus dieser Position kann das Verschlusskügelchen leicht manuell mittels eines Stempels in eine Bohrung einer Kappe eingedrückt werden (vgl. Verschlusskügelchen 55 in Bohrung 53 der Kappe 43), wodurch das Probengefäß (hier Probengefäß 41) verschlossen wird, insbesondere gasdicht verschlossen wird. Dabei wird die Kappe 43, 44 im Bereich der Bohrung 53, 54 elastisch gespreizt.

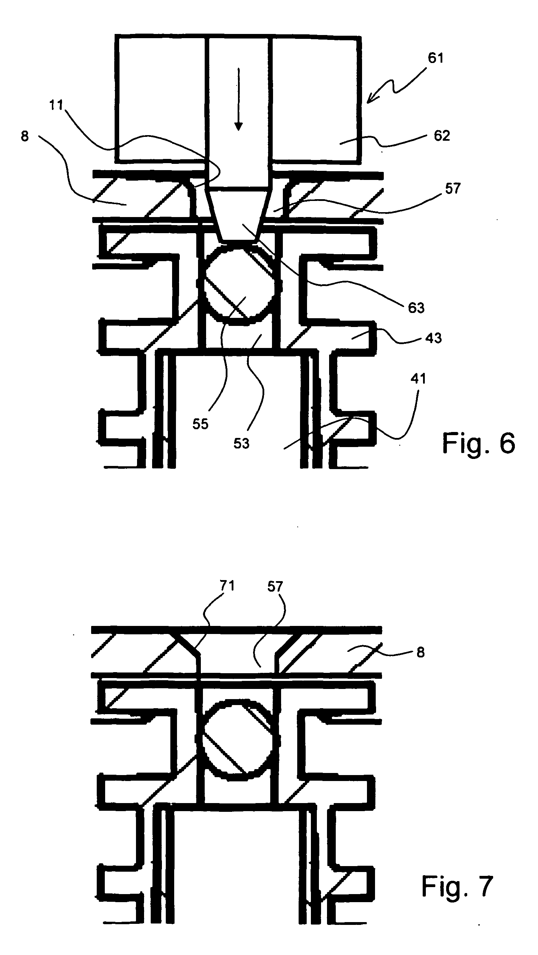

Ein solcher Eindrückvorgang mit einem Stempel 61 ist in Figur 6 illustriert. Der Stempel 61 weist ein hinteres Griffstück 62 und eine Stempelnase 63 auf. Letztere kann durch die Durchbruchöffnung 57 der Deckelplatte 8 und in die Bohrung 53 der Kappe 43 eingeschoben werden, und ein Verschlusskügelchen 55 vor sich her schieben. Die Stempelnase 63 wird dabei durch die Senke 11, die Durchbruchöffnung 57 und die Bohrung 53 geführt. Die hervorspringende Länge der Stempelnase 63 gegenüber dem Griffstück 62 begrenzt den Eindrückweg des Verschlusskügelchens 55, wenn das Griffstück 62 an der Deckelplatte 8 zum Anschlag kommt. Dadurch kann die endgültige Lage des Verschlusskügelchens 55 in der Bohrung 55 eingestellt werden.

Die in den Figuren 5 und 6 dargestellte trichterförmige Senke 11 ist über eine große Weite relativ flach und im zentrumsnahen Bereich sehr steil ausgebildet. Es sind jedoch auch andere Typen von trichterförmige Senken möglich, beispielsweise mit einem geraden Senkenrandverlauf, wie in Figur 7 mit Senke 71 illustriert, oder auch eine näherungsweise kugelkalottenförmige Senke. Bevorzugt werden scharfe Kanten im Bereich einer Senke bzw. einer Durchbruchöffnung vermieden.

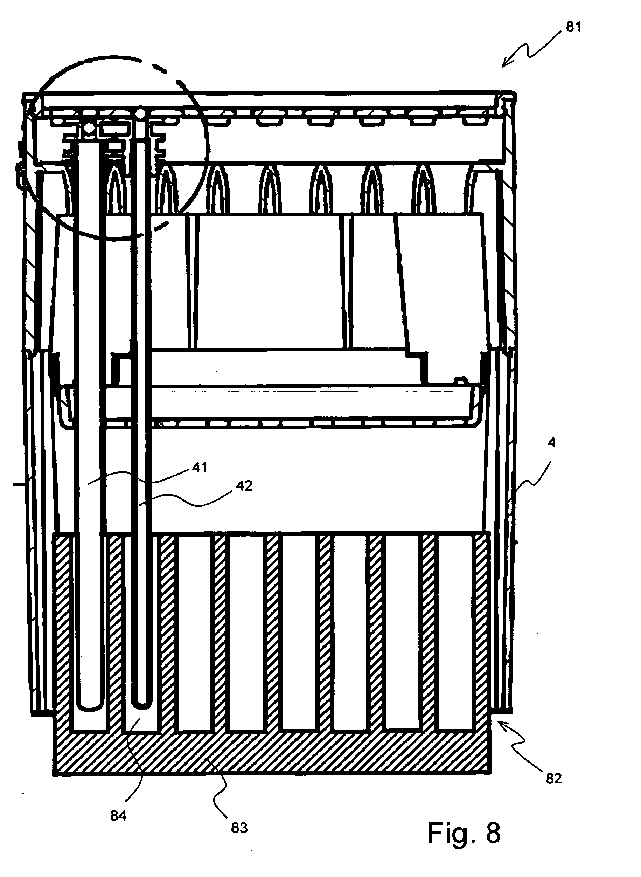

**Figur 8** zeigt schließlich noch eine andere Ausführungsform eines erfindungsgemäßen Systems mit Probengestell 81 mit unten offenem Bodenbereich 82 im schematischen Querschnitt. Durch diesen kann ein näherungsweise quaderförmiger Kühlblock 83 in das Probengestell 81 eingeschoben werden, insbesondere in das Gestell-Unterteil 4. Im Kühlblock 83 sind Bohrungen 84 vorgesehen, in die die unteren Enden der Probengefäße 41, 42 eingeführt sind.

## Patentansprüche

1. System zur Bereitstellung einer Vielzahl von Probengefäßen (41, 42), insbesondere Probenröhrchen,
umfassend ein Probengestell (30; 81) mit einer Vielzahl von Halterungen, in denen jeweils ein Probengefäß (41, 42) angeordnet ist,
wobei das System weiterhin Kappen (43, 44) umfasst, wobei jeweils eine Kappe (43, 44) über das offene Ende eines Probengefäßes (41, 42) gestülpt ist, wobei die Kappe (41, 42) eine Bohrung (53, 54) aufweist, durch die das Innere des Probengefäßes (41, 42) zugänglich ist,
und wobei das System weiterhin eine Vielzahl von Verschlusskügelchen (55, 56) umfasst, mit denen die Bohrungen (53, 54) der Kappen (43, 44) verschließbar sind,
**dadurch gekennzeichnet,**
**dass** das Probengestell (30; 81) eine abnehmbare Deckelplatte (8) aufweist, deren Unterseite im aufgesetzten Zustand der Deckelplatte (8) den Kappen (43, 44) der Probengefäße (41, 42) zugewandt ist,
und **dass** die Deckelplatte (8) an der Oberseite für jede Halterung eine näherungsweise trichterförmige Senke (11, 71) aufweist, in deren Mitte eine Durchbruchöffnung (57) durch die Deckelplatte (8) vorgesehen ist, wobei die Durchbruchöffnung (57) bei aufgesetzter Deckelplatte (8) mit der Bohrung (53, 54) einer Kappe (43, 44) eines darunter gehaltenen Probengefäßes (41, 42) fluchtet, und wobei die Durchbruchöffnungen (57) ausreichend groß sind, so dass die Verschlusskügelchen (55, 56) die Durchbruchöffnung (57) passieren können.

2. System nach Anspruch 1, **dadurch gekennzeichnet, dass** das Probengestell (30; 81) eine obere Halteplatte (5) aufweist, die Ausnehmungen (6) für die Probengefäße (41, 42) aufweist, wobei der Durchmesser der Ausnehmungen (6) größer ist als der Durchmesser der Probengefäße (41, 42), aber kleiner ist als der Außendurchmesser der Kappen (43, 44),
und dass die Probengefäße (41, 42) in die obere Halteplatte (5) eingehängt sind, wobei die Kappen (43, 44) auf der Halteplatte (5) aufliegen.

3. System nach einem der Ansprüche 1 bis 2, **dadurch gekennzeichnet, dass** das Probengestell (30; 81) einen nach unten offenen Bodenbereich (82) aufweist.

4. System nach einem der Ansprüche 1 bis 2, **dadurch gekennzeichnet, dass** das Probengestell (30; 81) eine Bodenplatte (16) aufweist, die mehrere Löcher (17) aufweist.

5. System nach Anspruch 4, **dadurch gekennzeichnet, dass** die Löcher (17) in der Bodenplatte (16) auf Zwischenräume zwischen gehaltenen Probengefäßen (41, 42) ausgerichtet sind,
insbesondere wobei jede Halterungsposition von vier Löchern (17) umgeben ist.

6. System nach einem der vorhergehenden Ansprüche, **dadurch gekennzeichnet, dass** das Probengestell (30; 81) zusammengesetzt ist aus
- einem Gestell-Unterteil (4), welches die gehaltenen Probengefäße (41, 42) in einem unteren Bereich der Probengefäße (41, 42) zumindest seitlich umgibt,
- einem Gestell-Oberteil (2), welches die gehaltenen Probegefäße (41, 42) in einem oberen Bereich der Probengefäße (41, 42) zumindest seitlich umgibt und die obere Halteplatte (5) enthält,
- und einem Deckel (1), welcher die Deckelplatte (8) enthält,
wobei das Gestell-Unterteil (4) mit dem Gestell-Oberteil (2) verklemmbar ist,
und wobei der Deckel (1) mit dem Gestell-Oberteil (2) verklemmbar ist.

7. System nach einem der vorhergehenden Ansprüche, **dadurch gekennzeichnet, dass** die Halterungen der Probengefäße (41, 42) gemäß dem "96er well plate"-Standard angeordnet sind.

8. Verwendung eines Systems nach einem der Ansprüche 1 bis 7 zum Verschließen von Probengefäßen (41, 42) mit Verschlusskügelchen (55, 56),
wobei Verschlusskügelchen (55, 56) auf der aufgesetzten Deckelplatte (8) verteilt werden,
und wobei jeweils ein in eine Durchbruchöffnung (57) gerolltes Verschlusskügelchen (55, 56) durch die Durchbruchöffnung (57) in die Bohrung (53, 54) einer Kappe (43, 44) eines darunter gehaltenen Probengefäßes (41, 42) eingedrückt wird, insbesondere manuell mittels eines Stempels (61).

9. Verwendung eines Systems nach einem der Ansprüche 1 bis 7 zur Probenpräparation und/oder Probenbereitstellung für Kernspinresonanz (=NMR)-Messungen,
insbesondere wobei die Probengefäße (41, 42) als NMR-Probenröhrchen ausgebildet sind.

10. Verwendung eines Systems nach einem der Ansprüche 1 bis 7 zur Kühlung von Probensubstanz in den Probengefäßen (41, 42).

11. Verwendung nach Anspruch 10 in Verbindung mit einem Probengestell (30; 81) nach Anspruch 3, **dadurch gekennzeichnet,**
**dass** durch den unten offenen Bodenbereich (82) ein näherungsweise quaderförmiger Kühlblock (83) in das Probengestell (30; 81) eingeschoben wird, welcher Bohrungen (84) aufweist, in die die gehaltenen Probengefäße (41, 42) eingeführt werden,
und **dass** der Kühlblock auf eine vorgegebene Temperatur, insbesondere um -196°C oder weniger, gekühlt ist.

12. Verwendung nach Anspruch 10 in Verbindung mit einem Probengestell (30; 81) nach Anspruch 4, **dadurch gekennzeichnet,**
**dass** durch einen Teil der Löcher (17) in der Bodenplatte (16) ein kühlender Gasstrom eingeblasen wird,
und **dass** durch einen Teil der Löcher (17) in der Bodenplatte (16) der kühlende Gasstrom ausströmt.

13. Verwendung nach Anspruch 10 in Verbindung mit einem Probengestell (30; 81) nach Anspruch 5, **dadurch gekennzeichnet,**
**dass** durch die Löcher (17) in der Bodenplatte (16) Kühlfinger (32) in das Probengestell (30; 81) eingeschoben werden, die zwischen die gehaltenen Probengefäße (41, 42) eingreifen,
insbesondere wobei die Kühlfinger die Probengefäße (41, 42) nicht berühren,
und **dass** die Kühlfinger (32) auf eine vorgegebene Temperatur, insbesondere um -196°C oder weniger, gekühlt sind.

## Claims

1. A system for providing a plurality of sample vessels (41, 42), in particular sample tubes,
comprising a sample frame (30; 81) having a plurality of retainers, in each of which a sample vessel (41, 42) is arranged,
the system further comprising caps (43, 44), wherein one cap (43, 44) each is put over the open end of a sample vessel (41, 42), the cap (41, 42) having a drilled hole (53, 54), through which the interior of the sample vessel (41, 42) is accessible,
and the system further comprising a plurality of closure beads (55, 56) which may close the drilled holes (53, 54) of the caps (43, 44),
**characterized in**
**that** the sample frame (30; 81) has a removable cover plate (8), the bottom side of which faces the caps (43, 44) of the sample vessels (41, 42) when the cover plate (8) is in a superimposed condition,
and **that** for each retainer the cover plate (8) has, on the top side, an approximately funnel-shaped depression (11, 71), in the center of which a through opening (57) is provided through the cover plate (8), with the through opening (57) being aligned with the drilled hole (53, 54) of a cap (43, 44) of a sample vessel (41, 42) retained underneath when the cover plate (8) is in the superimposed condition, and wherein the through openings (57) are sufficiently large to enable the closure beads (55, 56) to pass the through opening.

2. The system according to Claim 1, **characterized in that** the sample frame (30; 81) has an upper retention plate (5) with recesses (6) for the sample vessels (41, 42), the diameter of the recesses (6) being larger than the diameter of the sample vessels (41, 42), but being smaller than the outer diameter of the caps (43, 44),
and that the sample vessels (41, 42) are suspended in the upper retention plate (5), the caps (43, 44) resting on the retention plate (5).

3. The system according to any one of claims 1 to 2, **characterized in that** the sample frame (30; 81) has a floor area (82) open on the bottom.

4. The system according to any one of claims 1 to 2, **characterized in that** the sample frame (30; 81) has a floor plate (16) having multiple holes (17).

5. The system according to claim 4, **characterized in that** the holes (17) in the floor plate (16) are oriented to intermediate spaces between retained sample vessels (41, 42),
each retention position being enclosed by four holes (17) in particular.

6. The system according to any one of the preceding claims, **characterized in that** the sample frame (30; 81) is assembled from
- a frame bottom part (4), which at least laterally encloses the retained sample vessels (41, 42) in a lower area of the sample vessels (41, 42),
- a frame top part (2), which at least laterally encloses the retained sample vessels (41, 42) in an upper area of the sample vessels (41, 42) and contains the upper retention plate (5),
- and a cover (1) which contains the cover plate (8), the frame bottom part (4) being able to be clamped to the frame top part (2);
and the cover (1) being able to be clamped to the frame top part (2).

7. The system according to any one of the preceding claims, **characterized in that** the retainers of the sample vessels (41, 42) are arranged according to the "96-well plate" standard.

8. Use of a system according to any one of claims 1 to 7 for closing sample vessels (41, 42) using closure beads (55, 56),
wherein closure beads (55, 56) are distributed onto the superimposed cover plate (8),
and wherein one closure bead (55, 56) each rolled into a through opening (57) is pressed through the through opening (57) into the drilled hole (53, 54) of a cap (43,44) of a sample vessel (41, 42) retained underneath, in particular manually using a plunger (61).

9. Use of a system according to any one of claims 1 to 7 for sample preparation and/or sample provision for nuclear magnetic resonance (=NMR) measurements,
wherein the sample vessels (41, 42) are particularly implemented as NMR sample tubes.

10. Use of a system according to any one of claims 1 to 7 for cooling of a sample substance in the sample vessels (41, 42).

11. Use according to claim 10 in conjunction with a sample frame (30; 81) according to claim 3, **characterized in**
**that** an approximately cuboid cooling block (83) is pushed into the sample frame (30; 81) through the floor area (82) open on the bottom, wherein the cooling block (83) has holes (84), into which the retained sample vessels (41, 42) are inserted,
and **that** the cooling block is cooled to a predefined temperature, in particular at about -196°C or less.

12. Use according to claim 10 in conjunction with a sample frame (30; 81) according to claim 4, **characterized in**
**that** a cooling gas flow is blown through part of the holes (17) in the floor plate (16),
and **that** the cooling gas flow flows out through part of the holes (17) in the floor plate (16).

13. Use according to claim 10 in conjunction with a sample frame (30; 81) according to claim 5, **characterized in**
**that** cold fingers (32) are pushed into the sample frame (30; 81) through the holes (17) in the floor plate (16), wherein the cold fingers (32) engage between the retained sample vessels (41, 42),
the cold fingers not contacting the sample vessels (41, 42) in particular, and that the cool fingers (32) are cooled to a predefined temperature, in particular about -196°C or less.

## Revendications

1. Système de mise à disposition d'une pluralité de récipients d'échantillons (41, 42), en particulier de tubes à échantillon,
comprenant un porte-échantillons (30 ; 81) avec une pluralité de supports dans chacun desquels est disposé un récipient d'échantillons (41, 42),
le système comprenant en outre des capuchons (43, 44), un capuchon (43, 44) étant placé à chaque fois sur l'extrémité ouverte d'un récipient d'échantillons (41, 42), le capuchon (41, 42) présentant un orifice (53, 54) à travers lequel l'intérieur du récipient d'échantillons (41, 42) est accessible, et le système comprenant en outre une pluralité de billes de fermeture (55, 56) avec lesquelles les orifices (53, 54) des capuchons (43, 44) peuvent être fermés,
**caractérisé en ce**
**que** le porte-échantillons (30 ; 81) présente une plaque couvercle amovible (8) dont la face inférieure est tournée vers les capuchons (43, 44) des récipients d'échantillons (41, 42) quand la plaque couvercle (8) est montée, et que la plaque couvercle (8) présente sur la face supérieure pour chaque support un creux (11, 71) approximativement en forme d'entonnoir au milieu duquel est prévue une ouverture de passage (57) à travers la plaque couvercle (8), l'ouverture de passage (57) étant alignée avec l'orifice (53, 54) d'un capuchon (43, 44) d'un récipient d'échantillons (41, 42) maintenu en dessous quand la plaque couvercle (8) est montée, et les ouvertures de passage (57) étant suffisamment grandes pour que les billes de fermeture (55, 56) puissent passer par l'ouverture de passage (57).

2. Système selon la revendication 1, **caractérisé en ce que** le porte-échantillons (30 ; 81) présente une plaque de maintien supérieure (5) qui présente des évidements (6) pour les récipients d'échantillons (41, 42), le diamètre des évidements (6) étant plus grand que le diamètre des récipients d'échantillons (41, 42) mais plus petit que le diamètre extérieur des capuchons (43, 44),
et que les récipients d'échantillons (41, 42) sont accrochés dans la plaque de maintien supérieure (5), les capuchons (43, 44) reposant sur la plaque de maintien (5).

3. Système selon une des revendications 1 à 2, **caractérisé en ce que** le porte-échantillons (30 ; 81) présente une zone de fond ouverte vers le bas (82).

4. Système selon une des revendications 1 à 2, **caractérisé en ce que** le porte-échantillons (30 ; 81) présente une plaque de fond (16) qui comporte plusieurs trous (17).

5. Système selon la revendication 4, **caractérisé en ce que** les trous (17) dans la plaque de fond (16) sont alignés sur des espaces entre récipients d'échantillons (41, 42) maintenus,
chaque position de support étant en particulier entourée par quatre trous (17).

6. Système selon une des revendications précédentes, **caractérisé en ce que** le porte-échantillons (30 ; 81) est composé
- d'une partie inférieure de porte-échantillons (4) qui entoure au moins latéralement les récipients d'échantillons (41, 42) maintenus dans une zone inférieure des récipients d'échantillons (41, 42),
- d'une partie supérieure de porte-échantillons (2) qui entoure au moins latéralement les récipients d'échantillons (41, 42) maintenus dans une zone supérieure des récipients d'échantillons (41, 42) et contient la plaque de maintien supérieure (5),
- et d'un couvercle (1) qui contient la plaque couvercle (8),
la partie inférieure de porte-échantillons (4) pouvant être assemblé par serrage avec la partie supérieure de porte-échantillons (2),
et le couvercle (1) pouvant être assemblé par serrage avec la partie supérieure de porte-échantillons (2).

7. Système selon une des revendications précédentes, **caractérisé en ce que** les supports des récipients d'échantillons (41, 42) sont disposés selon la norme « 96-well plate ».

8. Utilisation d'un système selon une des revendications 1 à 7 pour fermer des récipients d'échantillons (41, 42) avec des billes de fermeture (55, 56),
des billes de fermeture (55, 56) étant réparties sur la plaque couvercle (8) montée,
et chaque bille de fermeture (55, 56) que l'on fait rouler dans une ouverture de passage (57) étant enfoncée à travers l'ouverture de passage (57) dans l'orifice (53, 54) d'un capuchon (43, 44) d'un récipient d'échantillons (41, 42) maintenu en dessous, en particulier manuellement au moyen d'un piston (61).

9. Utilisation d'un système selon une des revendications 1 à 7 pour la préparation et/ou la mise à disposition d'échantillons pour des mesures par résonance magnétique nucléaire (= RMN),
les récipients d'échantillons (41, 42) étant en particulier réalisés sous la forme de tubes à échantillon RMN.

10. Utilisation d'un système selon une des revendications 1 à 7 pour refroidir une substance échantillon dans les récipients d'échantillons (41, 42).

11. Utilisation selon la revendication 10 en relation avec un porte-échantillons (30 ; 81) selon la revendication 3, **caractérisé en ce**
**qu'**un bloc de refroidissement (83) approximativement parallélépipédique est enfoncé dans le porte-échantillons (30 ; 81) à travers la zone de fond ouverte vers le bas (82), lequel présente des orifices (84) dans lesquels les récipients d'échantillons (41, 42) maintenus sont introduit,
et **que** le bloc de refroidissement est refroidi à une température prédéfinie, en particulier de -196 °C ou moins.

12. Utilisation selon la revendication 10 en relation avec un porte-échantillons (30 ; 81) selon la revendication 4, **caractérisé en ce**
**qu'**un courant de gaz refroidissant est injecté à travers une partie des trous (17) dans la plaque de fond (16),
et **que** le courant de gaz refroidissant sort à travers une partie des trous (17) dans la plaque de fond (16).

13. Utilisation selon la revendication 10 en relation avec un porte-échantillons (30 ; 81) selon la revendication 5, **caractérisé en ce**
**que** des doigts de refroidissement (32) sont enfoncés dans le porte-échantillons (30 ; 81) à travers les trous (17) dans la plaque de fond (16), lesquels s'engagent entre les récipients d'échantillons (41, 42) maintenus,
les doigts de refroidissement ne touchant en particulier pas les récipients d'échantillons (41, 42),
et **que** les doigts de refroidissement (32) sont refroidis à une température prédéfinie, en particulier de -196°C ou moins.
